# FASCICULE DE BREVET EUROPEEN

(11) **EP 0 643 460 B1**
(45) Date de publication et mention de la délivrance du brevet: **19.03.1997**
(21) Numéro de dépôt: 94401984.3
(22) Date de dépôt: 07.09.1994
(51) Int. Cl.: H01S 3/103, H01S 3/25, G02F 2/00, H04B 14/02, H04J 14/00

(54) **Procédé de transposition d'une modulation optique, d'une longueur d'onde sur une autre longueur d'onde ajustable**
Verfahren zur abstimmbaren Wellenlängenänderung von moduliertem Licht
Method of tunable wavelength conversion of modulated light

(30) Priorité: 09.09.1993 FR 9310737
(43) Date de publication de la demande: 15.03.1995
(73) Titulaire: FRANCE TELECOM, 75015 Paris (FR)
(72) Inventeur: Dupont, Hervé, F-22300 Lannion (FR); Auffret, René, F-22700 Louannec (FR); Tromeur, André, F-22700 Louannec (FR)
(74) Mandataire: Signore, Robert

(56) Documents cités:
- IEEE PHOTONICS TECHNOLOGY LETTERS, vol.3, no.12, Décembre 1991, NEW YORK US pages 1054 - 1057, XP000242157 M.SCHILLING ET AL. 'Multifunctional photonic switching operation of 1500 nm Y-coupled cavity laser (YCCL) with 28 nm tuning capability'
- ELECTRONICS LETTERS., vol.27, no.23, 7 Novembre 1991, ENAGE GB pages 2183 - 2185, XP000268364 P.POTTIER ET AL. '1.5 Gbit/s transmission system using all optical wavelength convertor based on tunable two-electrode dfb laser'
- IEEE PHOTONICS TECHNOLOGY LETTERS, vol.4, no.10, Octobre 1992, NEW YORK US pages 1168 - 1171, XP000316548 J.M.WIESENFELD ET AL. 'cascadability and fanout of semiconductor optical amplifier wavelength shifter'
- ELECTRONICS LETTERS., vol.24, no.17, 18 Août 1988, ENAGE GB pages 1106 - 1107 G.GROSSKOPF ET AL. '140 Mbit/s DPSK transmission using an an all-optical frequency convertor with a 4000 Ghz conversion range'
- ELECTRONICS LETTERS., vol.25, no.20, 28 Septembre 1989, ENAGE GB pages 1360 - 1362, XP000255903 K.INOUE ET AL. 'Wavelenth conversion from FM light injection induced frequency shift in DFB-LD'

## Description

### Domaine technique

La présente invention a pour objet un procédé de transposition d'une modulation optique, d'une longueur d'onde sur une autre longueur d'onde ajustable.

Elle trouve une application en télécommunications optiques.

### Etat de la technique

L'introduction de l'optique dans les réseaux de télécommunications tient à la grande capacité de transmission qu'offrent les liaisons optiques. Afin de profiter pleinement de cet avantage et d'obtenir une transparence optique sur tout le réseau, il est nécessaire de limiter au maximum l'emploi de connexions optique/électrique et électrique/optique. C'est dans ce but que les amplificateurs optiques (à fibres dopées ou à semiconducteur) ont été développés. En assurant la régénération tout-optique des signaux, ils permettent de supprimer les répéteurs électriques.

Dans un réseau de télécommunications utilisant plusieurs longueurs d'onde (réseau dit "multicolore"), l'opération de routage (appelée commutation spatiale de circuits ou commutation en longueur d'onde) implique des fonctions de base qui sont remplies par des émetteurs accordables en longueur d'onde, des coupleurs étoiles de grande capacité ou des filtres optiques accordables. A ces fonctions doit être ajoutée celle de transposition de longueur d'onde consistant à transférer l'information d'une porteuse optique sur une autre. Elle permet non seulement l'aiguillage d'une information dans un réseau par "coloration" du signal, mais aussi la connexion entre deux réseaux locaux multicolores.

Pour obtenir cette transposition, une possibilité consiste à détecter l'information reçue sur une longueur d'onde et à utiliser le signal électrique résultant pour moduler un laser émettant à une autre longueur d'onde.

Un tel dispositif, capable de remplir cette fonction, peut se présenter sous deux formes différentes :
- dans la première, l'information se trouvant initialement sur une longueur d'onde λ₀ fixe est transposée vers une autre longueur d'onde λ_{*i*} choisie parmi n longueurs d'onde possibles ; on peut ainsi successivement accéder, en sortie du dispositif, à l'information sur l'une quelconque des gueurs d'onde λ₁,λ₂,...,λ_{*n*} ;
- dans la seconde, l'information parvient au dispositif sur une longueur d'onde λ_{*i*} sélectionnée entre n longueurs d'onde possibles et le dispositif transfère le signal sur une autre longueur d'onde fixe λ₀.

Jusqu'à présent, cette opération de transposition a été obtenue à l'aide de diodes lasers et d'amplificateurs à semi-conducteurs. Dans le premier cas, on agit sur la longueur d'onde d'émission d'un laser monomode de type DFB ("Distributed FeedBack") ou DBR ("Distributed Bragg Reflection"), par injection optique dans la zone active.

C'est ce qui est décrit dans les deux articles suivants :
- P. POTTIER, M.J. CHAWKI, R. AUFFRET, G. CLAVEAU, A. TROMEUR, "1.5 Gbit/s transmission system using all optical wavelength convertor based on tunable two-electrode DFB laser", Electron. Lett., vol. 27, pp. 2183-2184, 1991 ;
- B. MIKKELSEN, T. DURHUUS, R.J. PEDERSEN, K.E. STUBKJAER, "Penalty free wavelength conversion of 2.5 Gbit/s signals using a tuneable DBR-laser", Proc. ECOC'92, Berlin, septembre 1992.

Quant aux amplificateurs à semi-conducteurs, ils utilisent soit le phénomène de variation de saturation du gain, soit le mélange à quatre ondes, pour provoquer la transposition.

C'est ce qui est décrit dans les deux articles suivants :
- J.M. WIESENFELD, B. GLANCE, "Cascadability and fanout of semiconductor optical amplifier wavelength shifter", IEEE Photon. Technol. Lett., vol. 4, pp. 1168-1171, 1992 ;
- G. GROSSKOPF, R. LUDWIG, H.G. WEBER, "140 Mbit/s DPSK transmission using an all-optical frequency convertor with a 4000 GHz conversion range", Electron. Lett., vol. 24, pp. 1106-1107, 1988.

Malgré leurs performances intéressantes, ces différents procédés présentent un taux de complexité important, soit la mise en place du procédé est délicate (notamment en ce qui concerne l'ajustement des longueurs d'ondes des signaux incidents et transposés), soit ils nécessitent l'emploi d'un laser pompe.

La présente invention a justement pour but d'éviter ces inconvénients.

### Exposé de l'invention

A cette fin, l'invention propose un procédé qui consiste à :
- utiliser un laser amplificateur à semiconducteur, dont la sortie est rebouclée sur l'entrée par une boucle de rétroaction munie d'un filtre optique calé sur une première longueur d'onde λ₁, cet ensemble étant capable d'auto-osciller à ladite première longueur d'onde λ₁,
- injecter dans le laser amplificateur à semiconducteur un faisceau incident ayant une seconde longueur d'onde λ₂, ce faisceau incident étant modulé en amplitude, celle-ci passant alternativement d'un niveau haut à un niveau bas,
- régler la modulation de ce faisceau incident de telle sorte que, pour le niveau haut de l'amplitude du faisceau incident, la condition d'auto-oscillation du laser amplificateur rebouclé à la longueur d'onde λ₁ ne soit plus satisfaite, le laser amplificateur réalisant alors une simple amplification du signal à la seconde longueur d'onde λ₂ ; pour le niveau bas de l'amplitude du faisceau incident, l'auto-oscillation du laser amplificateur rebouclé étant rétablie, le laser amplificateur émettant sur ladite première longueur d'onde λ₁,
- la modulation d'amplitude du faisceau incident à la seconde longueur d'onde étant ainsi transposée en une modulation d'amplitude complémentaire, à la première longueur d'onde.

Ce procédé présente, sur les procédés connus, de nombreux avantages :
- tout d'abord, il évite l'usage d'un laser pompe. Le dispositif de mise en oeuvre ne comprend qu'un amplificateur semiconducteur et un filtre ; l'équipement est donc réduit ;
- ensuite, la sélection de la longueur d'onde vers laquelle s'effectue la transposition est obtenue par simple ajustement d'un filtre optique sur la boucle de rétroaction ; facile d'emploi, un tel filtre rend le choix de la longueur d'onde aisé et procure de la souplesse au dispositif ;
- par ailleurs, étant donné que l'on utilise un amplificateur semiconducteur, la longueur d'onde incidente λ₁ et la longueur d'onde transposée λ₂ peuvent être choisies sur toute la courbe de gain de l'amplificateur ; cet élément rend ce type de transposition particulièrement attrayant ;
- enfin, si la réflectivité résiduelle des faces de l'amplificateur à semiconducteur subsiste en partie (de l'ordre de 10⁻⁴), de petites résonances apparaissent sur sa courbe de gain ; il est donc possible d'utiliser ces résonances pour définir un peigne de longueurs d'onde pour lesquelles l'effet laser et la transposition est obtenue de manière privilégiée.

### Brève description des dessins

- la figure 1 est un schéma de principe d'un laser amplificateur à semiconducteur à boucle de rétroaction ;
- la figure 2 montre les spectres d'émission de l'amplificateur à semiconducteur sans rétroaction (a) et avec rétroaction (b) ;
- la figure 3 est un schéma d'un montage expérimental permettant de mettre en oeuvre et de tester le procédé de l'invention ;
- la figure 4 montre le spectre d'émission de l'amplificateur muni de sa boucle de rétroaction sans faisceau injecté (a) et avec faisceau injecté (b) ;
- la figure 5 montre les modulations complémentaires du faisceau incident et du faisceau transposé.

### Exposé détaillé d'un mode de réalisation

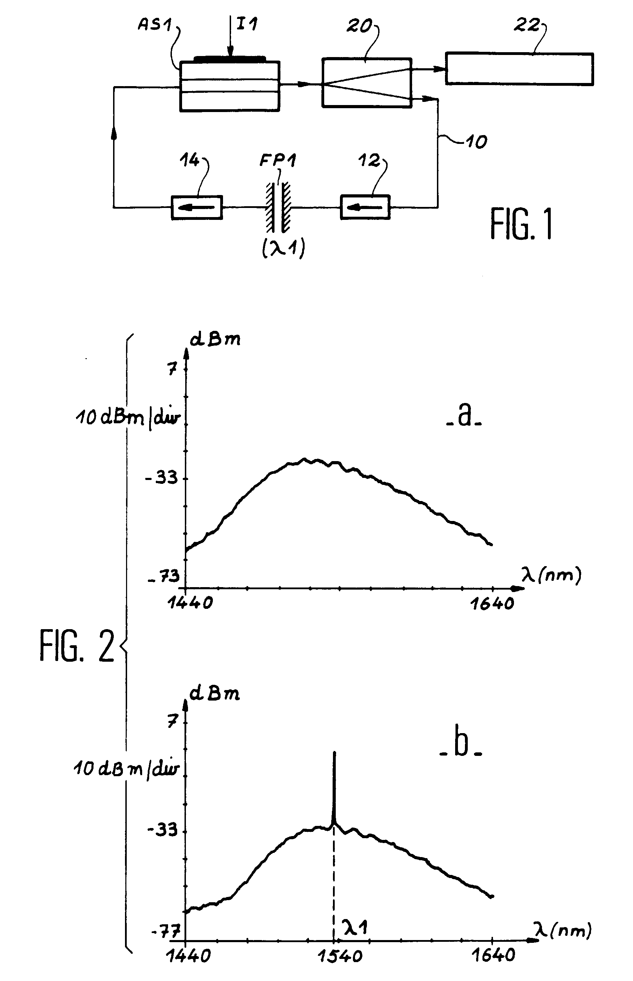

Le dispositif représenté sur la figure 1 comprend un laser amplificateur AS1, dont la sortie optique est rebouclée sur l'entrée par une boucle 10 en fibre optique. Cette boucle comprend un premier isolateur 12, un filtre optique qui peut être un étalon FABRY-PEROT FP1, et un second isolateur 14.

Les isolateurs évitent tout retour, dans l'amplificateur à semiconducteur, de lumière se trouvant spectralement en dehors de la bande passante du filtre.

Pour étudier le fonctionnement d'un tel ensemble, il est utile d'insérer un coupleur optique 20 à une entrée et deux sorties, l'une des sorties étant reliée à la boucle 10, l'autre à un analyseur 22. Cet analyseur permet de relever des spectres tels que ceux de la figure 2.

Sur la partie (a) de la figure 2, on voit le spectre de l'émission spontanée obtenue sans rétroaction, c'est-à-dire à boucle ouverte. Sur la partie (b), on voit le spectre avec rétroaction, avec son pic d'auto-oscillation. La longueur d'onde λ1 de ce pic est définie par le filtre FP1. Dans l'exemple illustré, λ1 est à 1540 nm.

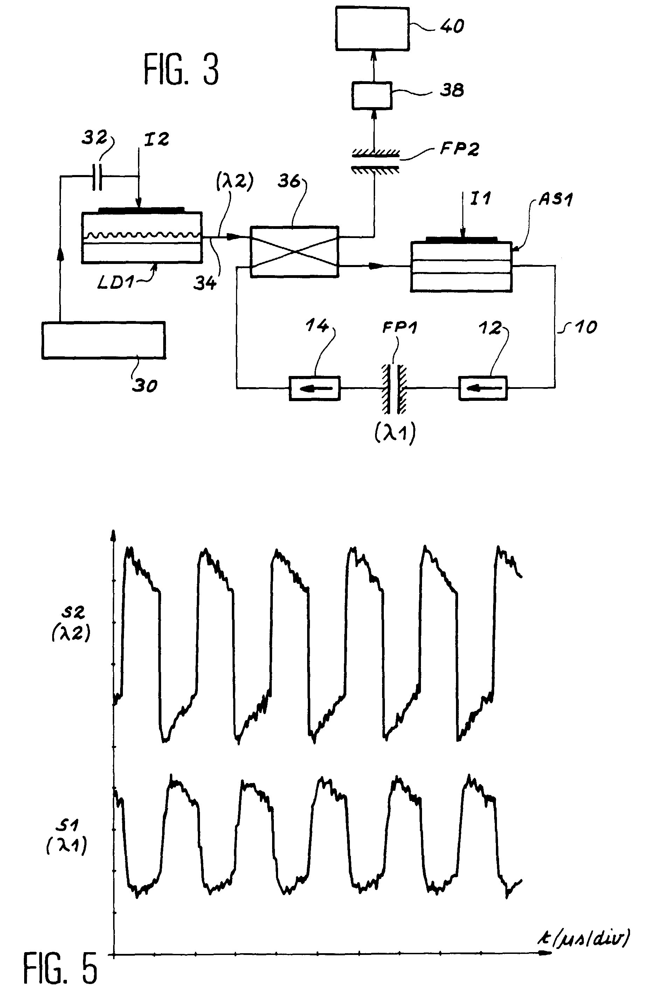

La figure 3 montre un dispositif expérimental permettant de tester les performances du procédé de l'invention. On y retrouve l'amplificateur à semiconducteur AS1 alimenté par un courant I1 et sa boucle de rétroaction 10, avec son filtre FP1 définissant λ1.

On trouve, par ailleurs, une diode laser mono-électrode LD1 alimentée par un courant I2 et modulée en courant par un générateur 30 relié à l'électrode à travers un condensateur 32. Cette diode laser émet un faisceau 34 qui est à une longueur d'onde λ2. Ce faisceau est donc modulé en amplitude au rythme imposé par le générateur 30 et c'est ce signal optique qu'il s'agit de transposer.

Le montage comprend encore un coupleur deux vers deux 36, un second FABRY-PEROT FP2, un photodétecteur 38, par exemple une diode PIN, et un oscilloscope 40.

A titre d'exemple non limitatif, les conditions expérimentales dans lesquelles la validité du procédé de l'invention a été vérifiée, sont données ci-dessous. Les faces de l'amplificateur laser AS1 sont traitées avec des couches antireflet pour faire tomber leur réflectivité à environ 10⁻⁵. Le courant I1 est de 68,3 mA. La finesse du FABRY-PEROT FP1 peut être de 100 et sa largeur à mi-hauteur de 0,33 nm (43 GHz). L'auto-oscillation de l'amplificateur ainsi rebouclé a été fixée à λ1=1528,1 nm par la position du filtre optique FP1.

Le courant d'alimentation I2 de la diode laser LD1 est modulé autour de 34,1 mA. La longueur d'onde λ2 correspondant est λ2=1543,1 nm.

Le second filtre FABRY-PEROT FP2 est destiné à sélectionner la longueur d'onde souhaitée λ₁ ou λ₂ selon que l'on visualise le signal source ou le signal transposé. Il a une finesse de 100 et une largeur à mi-hauteur de 0,1 nm (13 GHz).

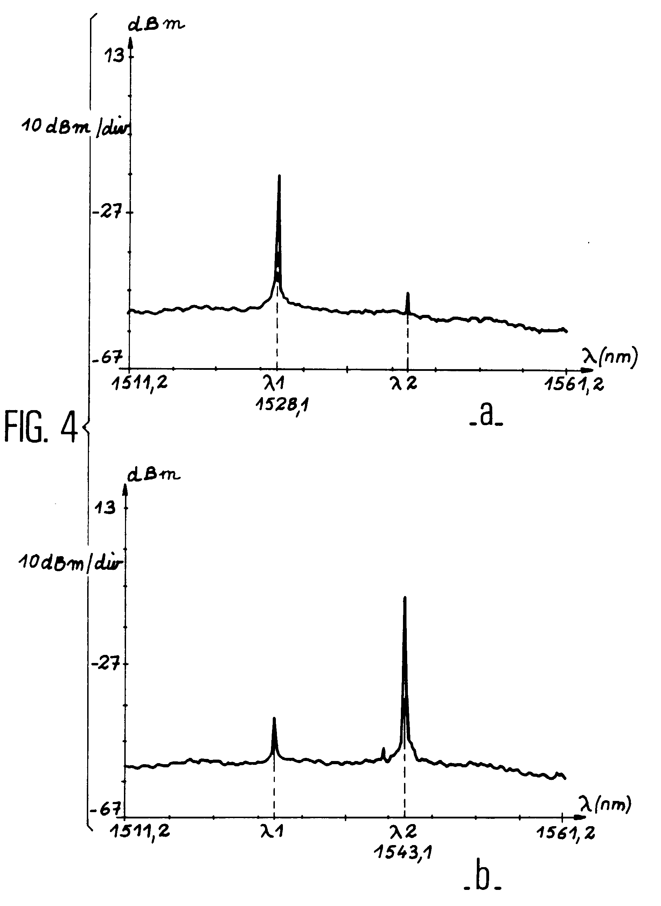

La figure 4 montre les résultats observés. La partie (a) montre le spectre obtenu sans faisceau incident. La raie présente à λ₁=1528,1 nm est la raie d'auto-oscillation de l'amplificateur AS1 rebouclé sur lui-même. La partie (b) montre le spectre avec un faisceau incident de puissance optique 74 µW injecté dans l'amplificateur laser. On voit que l'oscillation à λ₁ est pratiquement éteinte, l'extinction étant d'environ 25 dB et que domine une oscillation à 1543,1 nm qui est la longueur d'onde λ₂ du faisceau incident 34.

L'explication de cette transposition est la suivante. Comme le faisceau incident injecté dans l'amplificateur à semiconducteur est modulé en amplitude, cette amplitude (ou la puissance du faisceau injecté) passe alternativement par un niveau bas et un niveau haut. On passe donc, alternativement, d'un régime auto-oscillant, tel que celui de la partie (b), à un régime d'injection, où l'auto-oscillation est éteinte comme sur la partie (a).

La transposition de la modulation apparaît mieux sur la figure 5, qui présente l'allure des signaux S1 et S2 correspondant aux deux longueurs d'onde λ₁ et λ₂. Le signal du haut correspond au signal incident, alors que le signal du bas représente le signal transposé. On récupère sur la longueur d'onde λ₁ la modulation complémentaire de celle du signal incident.

Dans l'étude décrite, le laser LD1 était modulé à 300 kHz, ce qui peut sembler faible. Cette limitation est due au fait que la boucle de rétroaction s'étendait sur une dizaine de mètres de fibre optique. Etant donnée cette longueur, le temps d'instauration d'un régime stationnaire dans l'amplificateur était obligatoirement long (1 µs). Cependant, il est clair qu'en réduisant considérablement la taille de la boucle, il est possible de monter à des taux de répétition d'une centaine de Mbit/s, sans problème majeur.

Dans la description qui précède, l'accent a été mis sur les étalons FABRY-PEROT pour la réalisation de filtre optique. Il est bien clair que l'invention n'est pas limitée à ce cas et que tout filtre optique peut convenir (filtre à réseau, etc...).

## Revendications

1. Procédé de transposition d'une modulation optique d'une longueur d'onde (λ₂) sur une longueur d'onde ajustable, caractérisé par le fait qu'il consiste à :
- utiliser un laser amplificateur à semiconducteur (AS1), dont la sortie est rebouclée sur l'entrée par une boucle de rétroaction (10) munie d'un filtre optique (FP1) calé sur une première longueur d'onde (λ₁), l'amplificateur rebouclé étant capable d'auto-osciller à ladite première longueur d'onde (λ₁),
- injecter dans le laser amplificateur à semiconducteur (AS1), un faisceau incident (34) ayant une seconde longueur d'onde (λ₂), ce faisceau incident (34) étant modulé en amplitude, celle-ci passant alternativement d'un niveau haut à un niveau bas,
- régler la modulation de ce faisceau incident (34) de telle sorte que pour le niveau haut de l'amplitude du faisceau incident (34) la condition d'auto-oscillation du laser amplificateur à la première longueur d'onde (λ₁) ne soit plus satisfaite, le laser amplificateur (AS1) réalisant alors une simple amplification du signal à la seconde longueur d'onde (λ₂) ; pour le niveau bas de l'amplitude du faisceau incident (34), l'auto-oscillation du laser amplificateur (AS1) rebouclé étant rétablie, le laser amplificateur (AS1) émettant alors sur ladite première longueur d'onde (λ₁),
- la modulation d'amplitude du faisceau incident (34) à la seconde longueur d'onde (λ₂) étant ainsi transposée en une modulation d'amplitude complémentaire sur la première longueur d'onde (λ₁).

2. Procédé selon la revendication 1, caractérisé par le fait que le laser amplificateur (AS1) avec sa boucle de rétroaction (10) est capable d'auto-osciller sur une pluralité de modes de longueurs d'onde différentes, l'une de ces longueurs d'onde (λ₁) pouvant être sélectionnée en accordant le filtre (FP1) placé dans la boucle de rétroaction (10) à cette longueur d'onde (λ₁) et la longueur d'onde (λ₂) du faisceau incident (34) étant réglée sur une autre de ces longueurs d'onde, la transposition s'effectuant ainsi de l'un des modes sur un autre.

3. Procédé selon la revendication 1, caractérisé par le fait que l'on utilise comme filtre optique un étalon FABRY-PEROT (FP1).

## Patentansprüche

1. Verfahren zur Übertragung einer optischen Modulation einer optischen Wellenlänge (λ₂) auf eine einstellbare Wellenlänge, dadurch gekennzeichnet, daß es umfaßt:
- Verwendung eines Halbleiterlaserverstärkers (AS1), dessen Ausgang rückgekoppelt ist auf den Eingang durch eine Rückkopplungsschleife (10), die mit einem optischen Filter (FP1) versehen ist, der auf eine erste Wellenlänge (λ₁) festgelegt ist, wobei der rückgekoppelte Verstärker in der Lage ist, bei der ersten Wellenlänge (λ₁) Auto-Oszillationen auszuführen,
- Einführeneines Einfallstrahles (34) in den Halbleiterlaserverstärker (AS1), der eine zweite Wellenlänge (λ₂) aufweist, wobei dieser Einfallstrahl (34) in seiner Amplitude moduliert ist, die zwischen einem hohen Niveau und einem niedrigen Niveau wechselt,
- Regulieren der Modulation des Einfallstrahls (34) in der Weise, daß für das hohe Niveau der Amplitude des Einfallstrahls (34) die Bedingung der Auto-Oszillation des Laserverstärkers bei der ersten Wellenlänge (λ₁) nicht erfüllt ist, wobei der Laserverstärker (AS1) demnach eine einfache Verstärkung des Signals bei der zweiten Wellenlänge (λ₂) bewirkt; für das niedrige Niveau der Amplitude des Einfallstrahls (34) die Auto-Oszillation des rückgekoppelten Laserverstärkers (AS1) bewirkt wird, wobei der Laserverstärker (AS1) demnach auf der ersten Wellenlänge (λ₁) emittiert,
- Amplitudenmodulieren des Einfallstrahls (34) bei der zweiten Wellenlänge (λ₂), die demnach in eine Amplitudenmodulation komplementär zur ersten Wellenlänge (λ₁) übertragen wird.

2. Verfahren nach Anspruch 1, dadurch gekennzeichnet, daß der Laserverstärker (AS1) mit der Rückwirkungsschleife (10) in der Lage ist, auf eine Anzahl von Moden mit verschiedenen Wellenlängen autozuoszillieren, wobei eine dieser Wellenlängen (λ₁) ausgewählt werden kann gemäß dem Filter (FP1), der in der Rückwirkungsschleife (10) bei dieser Wellenlänge (λ₁) angeordnet ist, und daß die Wellenlänge (λ₂) des Einfallstrahls (34) auf eine andere dieser Wellenlängen geregelt ist, wobei sich die Übertragung von einem Modus zu einem anderen vollzieht.

3. Verfahren nach Anspruch 1, dadurch gekennzeichnet, daß als optischer Filter ein Fabry-Perot-Gitter (FP1) verwendet wird.

## Claims

1. Process for the transposition of an optical modulation of a wavelength (λ₂) on an adjustable wavelength, characterized in that it consists of:
using a semiconductor amplifier laser (AS1), whose output is relooped on the input by a feedback loop (10) provided with an optical filter (FP1) tuned to a first wavelength (λ₁), the said means being able to self-oscillate at said wavelength (λ₁),
injecting into the semiconductor amplifier laser (AS1) an incident beam (34) having a second wavelength (λ₂), said incident beam (34) being amplitude-modulated and passing alternately from a high level to a low level,
regulating the modulation of this incident beam (34) in such a way that for the high amplitude level of the incident beam (34), the self-oscillation condition of the amplifier laser (AS1) relooped on the wavelength (λ₁) will no longer be satisfied, the amplifier laser then performing a simple amplification of the signal at the second wavelength (λ₂), whereas for the low amplitude level of the incident beam (34), the self-oscillation of the relooped amplifier laser (AS1) is reestablished, the amplifier laser (AS1) emitting on said first wavelength (λ₁),
the amplitude modulation of the incident laser (34) at said second wavelength (λ₂) thus being transposed into a complimentary amplitude modulation at the first wavelength (λ₁).

2. Process according to claim 1, characterized in that the amplifier laser (AS1) with its feedback loop (10) is able to self-oscillate on a plurality of modes of different wavelength, one of the wavelengths (λ₁) being selectable by tuning the filter (FP1) placed in the feedback loop (10) to said wavelength (λ₁) and the wavelength (λ₂) of the incident beam (34) is set to another of the wavelengths, so that the transposition takes place from one mode to another.

3. Process according to claim 1, characterized in that an air wedge (FP1) is used as the optical filter.
